Europäisches Patentamt

European Patent Office

Office européen des brevets

(19)

(11) **EP 0 990 715 B1**

(12) **EUROPÄISCHE PATENTSCHRIFT**

(45) Veröffentlichungstag und Bekanntmachung des Hinweises auf die Patenterteilung:
**28.11.2001 Patentblatt 2001/48**

(51) Int Cl.⁷: **C23C 14/00**, C09C 1/00

(21) Anmeldenummer: **99113067.5**

(22) Anmeldetag: **06.07.1999**

(54) **Bandbedampfungsanlage zur Herstellung von planparallelen Plättchen**

Belt-type vapour deposition unit for the production of plane-parallel lamina

Unité de déposition en phase gazeuse à courroie pour la production de feuille à faces parallèles

(84) Benannte Vertragsstaaten:
**CH FI FR GB IT LI NL**

(30) Priorität: **28.09.1998 DE 19844357**

(43) Veröffentlichungstag der Anmeldung:
**05.04.2000 Patentblatt 2000/14**

(73) Patentinhaber: **Weinert, Hilmar, Dipl.-Ing.**
**87600 Kaufbeuren (DE)**

(72) Erfinder: **Weinert, Hilmar, Dipl.-Ing.**
**87600 Kaufbeuren (DE)**

(74) Vertreter: **Winter, Brandl, Fürniss, Hübner, Röss, Kaiser, Polte, Partnerschaft**
**Patent- und Rechtsanwaltskanzlei**
**Bavariaring 10**
**80336 München (DE)**

(56) Entgegenhaltungen:
**DE-A- 4 020 999       US-A- 4 113 815**
**US-A- 4 168 986**

EP 0 990 715 B1

## Beschreibung

Die Erfindung betrifft eine Bandbedampfungsanlage zur Herstellung von planparallelen Plättchen.

Seit einigen Jahren besteht erhöhtes Interesse an planparallelen Plättchen, die auch "flakes" genannt werden, um diese als Pigmente in Lacken und Druckfarben, als Katalysatormaterial, als Ausgangsprodukt für magnetische und elektrische Abschirmungen und als Ausgangsmaterial für Leitlacke zu verwenden. Planparallele Plättchen zeichnen sich im Unterschied zu den klassischen, nach einem Mahlverfahren hergestellten Pigmenten, welche mehr oder weniger kugelförmig sind, durch eine höhere Brillianz sowie dadurch aus, daß ihre Einsatzmenge in einem Lack als Pigment wesentlich geringer ist. So haben beispielsweise Plättchen aus Aluminium, die nach dem PVD-Verfahren (physical vapour deposition) hergestellt wurden, typischerweise eine Dicke von 30-500 Nanometer; ihre flächigen Abmessungen betragen zwischen 5 und 50 Mikrometer. Bereits 3-4 Lagen solcher Aluminium-Plättchen erzeugen bei Einsatzgewichten von nur 0,3 bis 0,4 g/m$^2$ eine optisch deckende Schicht.

Solche planparallele Plättchen werden nach dem Stand der Technik nach einem aufwendigen, diskontinuierlichen Dreistufen-Verfahren hergestellt. Die hohen Kosten dieses Verfahrens und die geringen Herstellmengen lassen die Verwendung in Massenprodukten, wie in Metallic-Lackierungen oder Druckfarben, nicht zu.

Ein Beispiel für die Herstellung nach einem diskontinuierlichen Mehrstufenverfahren ist die Erzeugung von optisch veränderlichen Pigmentplättchen, die zur Erhöhung der Fälschungssicherheit auf Banknoten verwendet werden, wie es in der Schrift EP 227423 offenbart ist. Ähnliche Produkte und Verfahren sind im US-Patent 5278590 dargestellt.

Bei einem im US-Patent 4434010 dargestellen Verfahren wird kein Trennmittel verwendet. Statt dessen erfolgt die Aufdampfung direkt auf eine Kunststoffolie, welche danach zerkleinert und in einem geeigneten Lösungsmittel vollständig aufgelöst wird. Als Ergebnis bleibt die zu Teilchen zerfallene Aufdampfschicht als Suspension zurück. In allen vorstehend dargelegten Fällen werden große Mengen Lösungsmittel zum Auswaschen des Produktes benötigt. Diese müssen entweder aufgearbeitet oder entsorgt werden.

Zusammenfassend läßt sich also zum Stand der Technik die Aussage treffen, daß bei allen bekannten PVD-Verfahren zur Herstellung von planparallelen Plättchen mit Ausnahme des US-Patents 4434010 folgende Stufen durchlaufen werden:

- Aufbringen eines Trennlackes auf einen Polyesterfolienträger durch Bedrucken und Trocknen, wobei dieser Prozeß auf klassischen Rasterwalzen-Druckmaschinen für rollenförmiges Material an der Atmosphäre unter Ex-Schutz-Bedingungen ausgeführt wird,

- Aufdampfen der Schichten in Folge unter Hochvakuum, zum Teil durch mehrere Hin- und Herläufe des Folienträgers in der Vakuumanlage, sowie Entnahme der bedampften Rolle, und

- Entfernen des Schichtpaketes durch Auflösen des Tennmittellackes in einem Lösungsmittel (Azeton, Aethylazetat) und Ausfiltern des Produktes aus dem Lösungsmittel, wobei hierzu eine Schab- und Bürsteinrichtung in einem Lösungsmittelbad, durch welches die Folienbahn läuft, verwendet wird und das Produkt anschließend ausgefiltert wird und in die Weiterverarbeitung geht.

Der Einsatz von im Vakuum aufgedampften anorganischen Trennmitteln wird für andere Anwendungen von Rosenfeld im US-Patent 5156720 beschrieben. Auch bei diesem Verfahren wird ein Folienträger, vorzugsweise einer aus Polyesterfolie, verwendet, wobei dieser Folienträger aufgrund der starken Beanspruchung durch das Verfahren nur einmal verwendbar ist. Da aus einem Quadratmeter Folie mit einem Gewicht von 16,8 g unter Verwendung von Trennmittel in einer Menge von ca. 6 g/m$^2$ bei der Herstellung ein Quadratmeter Aluminium-Plättchen mit einer Dicke von 30 Nanometer und einer Masse von 0.091 g erzeugt wird, beträgt die Ausbeute nach Gewicht nur 1/272 der eingesetzten Folie und des Trennmittel-Lackes. Somit ist diese Methode unwirtschaftlich. Bei Verwendung eines aufgedampften Trennmittels mit etwa 0.1 g/m$^2$ sind die Verhältnisse etwas günstiger, jedoch beträgt das Verhältnis immer noch nur 1/180. In allen Fällen handelt es sich um einen diskontinuierlichen Prozeß, welcher auf 2 oder 3 verschiedenen Maschinen nacheinander durchgeführt werden muß. Entsprechend hoch sind die Herstellkosten, welche einen breiteren Einsatz des Produktes bisher verhinderten. Bestimmte Aufdampf- oder Sputtermaterialien lassen sich überhaupt nicht auf einem Folienträger auftragen, da deren thermische Belastbarkeit zu gering ist.

Die Aufgabenstellung der vorliegenden Erfindung besteht nun darin, eine Bandbedampfungsanlage zur Herstellung von planparallelen Plättchen und ein Herstellungsverfahren für solche Plättchen vorzusehen, wobei die Herstellungskosten geringer sind, eine höhere Lebensdauer sowie ein höherer Produktausstoß der verwendeten Anlage sichergestellt wird und erhöhten Sicherheitsanforderungen Rechnung getragen wird.

Erfindungsgemäß werden diese verschiedenen Aufgabenstellungen durch eine Bandbedampfungsanlage nach Anspruch 1 und ein Verfahren nach Anspruch 10 gelöst.

Entsprechend der Erfindung befinden sich in einer Aufdampfkammer eine erste und eine zweite Verdampfungseinrichtung, die auf einen Träger eine Trennmittelschicht sowie zumindest eine weitere Schicht aufbringen. In einer Ablösekammer wird dann mittels einer Ablöseeinrichtung das Trennmittel und die weitere Schicht in einer solchen Weise vom Träger entfernt, daß das Trennmittel in gelöstem Zustand und die weitere Schicht in Form von planparallelen Plättchen vorliegt. Der Druck ist in der Ablösekammer höher als in der Aufdampfkammer sowie niedriger als der Atmosphärendruck. Somit wird eine Vorrichtung vorgesehen, bei der durch den kontinuierlichen Prozeß die Herstellungskosten für planparallele Plättchen verringert sind, eine hoher Produktausstoß vorliegt, die Lebensdauer der Bauteile bedingt durch die gleichmäßige mechanische Belastung hoch ist, sowie den Sicherheitsstandards entsprochen wird.

Die Schicht kann in einer Ausführungsform Metall, Metalloxid oder Fluorid und eine weitere verdampfbare Substanz aufweisen, wodurch bei geringem Materialeinsatz ein gut deckender Lack erzeugbar ist.

Die Kapazität der Vorrichtung läßt sich weiter erhöhen, wenn durch die zweite Verdampfungseinrichtung zwei Schichten erzeugt werden, die durch ein Trennmittel getrennt sind.

Vorzugsweise gelangt ein im Hochvakuum unzersetzt verdampfbarer wasserlöslicher Stoff aus der Gruppe der Chloride, Fluoride und Borate als Trennmittel zum Einsatz, wodurch als Lösungsmittel nichtbrennbare Substanzen verwendbar sind und aufgrund der Schichtdicke, die sehr gering gestaltbar ist, nur ein geringer Materialeinsatz notwendig ist. Alternativ dazu sind auch Bromide, Jodide, Sulfate, Antimontrioxid, Boroxid, Natriumhydroxid oder Kaliumhydroxid einsetzbar.

Durch die Verwendung von Wasser als Lösungsmittel verbessert sich die Sicherheit der Gesamtanlage. Durch verzweige oder unverzweigte primäre Alkohole, sekundären und tertiären Alkohol als Lösungsmittel lassen sich die Vakuumverhältnisse in der Vakuumkammer noch günstiger gestalten.

Der Träger kann aus eine rostfreien Stahllegierung, Nickel oder einem galvanisch oder organisch beschichteten Metall sein. Dadurch ergeben sich eine gute thermische Belastbarkeit sowie eine hohe mechanische Belastbarkeit des Trägers. Alternativ eignet sich aufgrund der guten thermischen und mechanischen Eigenschaften auch Polyimidfolie als Träger. Bezüglich Eigenschaften und Kosten bevorzugte Trägerdicken sind 20 bis 2000µm.

Zwischen der Aufdampf- und der Ablösekammer sind in einer Ausführungsform dynamisch gepumpte Schleusen angeordnet, wodurch die Prozeßbedingungen in den Kammern getrennt voneinander optimal einstellbar sind.

Erfindungsgemäße werden planparallele Plättchen hergestellt, indem ein Trennmittel und eine weitere Schicht auf den Träger aufgebracht werden und diese dann in einer Suspension derart aufbereitet werden, daß die weitere Schicht in Form von planparallelen Plättchen vorliegt. Dabei ist der Druck bei der Suspensionsbildung niedriger als der Atmosphärendruck jedoch höher als der Druck im Aufbringschritt. Somit liegt ein effektives Verfahren zur kontinuierlichen Erzeugung von planparalleln Plättchen bei hoher Anlagenlebensdauer und hohem Produktausstoß vor.

Die weitere Schicht kann in Form einer ersten Schicht, einer Trennmittelschicht und im Anschluß daran einer zweiten Schicht vorliegen, wodurch eine hohe Effizienz bei der Erzeugung planparalleler Plättchen erzielt werden kann.

Der Gesamtprozeß kann somit in einer gekapselten Anlage unter hoher Reinheit staubfrei ablaufen, ohne daß eine kostenträchtige Reinraum-Umgebung geschaffen werden muß.

Als Träger können ein Endlosband oder ein Band zwischen zwei Wicklern, die jeweils zum Abwickeln und zum Aufwickeln verwendet werden, sein

Zusammenfassend läßt sich feststellen, daß mit der erfindungsgemäßen Ausgestaltung die thermische Belastbarkeit des Trägers bei der Bedampfung von Mehrfachschichten erhöht wird, der Einsatz von brennbaren Lösungsmitteln bei der Trennmittelbeschichtung und beim Ablösen des Produktes vom Träger weitestgehend vermieden wird, das Trennmittel seine Funktion auch bei sehr geringer Schichtdicke erfüllt sowie einfach auf den Träger aufbringbar und von diesem entfernbar ist und der Träger eine sehr lange Lebensdauer aufweist sowie ausreichend thermisch und mechanisch belastbar ist.

Erfindungsgemäße Weiterbildungen sind Gegenstand der weiteren Unteransprüche.

Nachfolgend wird die Erfindung unter Bezugnahme auf die beiliegenden Zeichnungen beschrieben, bei denen:

Fig. 1 eine erfindungsgemäße Bedampfungsanlage zeigt und

Fig. 2 den Schichtenaufbau und die Schichtenablösung im Verlauf eines Zyklus eines Trägers darstellt.

Die erfindungsgemäße Bedampfungsanlage weist im wesentlichen eine Vakuumkammer 1 auf, die durch eine oder mehrere dynamischen Schleusen 6a, 6b in eine Aufdampfkammer 2, die nachfolgend als Aufdampfteil bezeichnet wird, und eine Ablösekammer 7, die nachfolgend als Kammerteil bezeichnet wird, unterteilt ist. Im Aufdampfteil 2 und im Kammerteil 7 verläuft ein Endlosband 5 als Träger. Auf diesen Träger 5 werden unter einem Vakuum von weniger als $10^{-3}$ mbar nacheinander ein wasserlösliches Trennmittel als dünne Schicht von etwa 5 bis 100 Nanometer Dicke aus einem Verdampfer 3 und danach aus weiteren Verdampfern 4a, 4b, 4c die gewünschten Metalle, Oxide, Metalloxide, Fluoride, die das Produkt darstellen, aufgedampft. Die Anlage kann dabei mit nur geringen Veränderungen sowohl als Bedampfungsanlage nach dem PVD-Verfahren, wie auch als nach dem Sputter- oder PECVD-Verfahren (plasma enhanced chemical vapour deposition) betrieben werden.

Im Kammerteil 7 findet die Produktablösung vom Träger 5 statt. Die Druckbedingungen in diesem Kammerteil 7 sind so gestaltet, daß dort ein Vakuum von größer als 4 mbar herrscht. In der Praxis finden zwischen 20 und 200 mbar Verwendung. Die Ablösung unter Vakuum ist energetisch erheblich günstiger als die eingangs beschriebene Ablösung bei Umgebungsdruck, da die Drucksprünge zwischen den Stationen wesentlich geringer sind und auch weniger Aufwand zur Abdichtung der Schleusen gegeneinander betrieben werden muß.

Genauer gesagt erfolgt die Auflösung des Trennmittels erfindungsgemäß in Wasser, wodurch die Bedingung vorliegen muß, daß im Kammerteil 7 ein Druck herrscht, der ausreichend hoch über dem Wasserdampfdruck bei der Arbeitstemperatur liegt. Es ist zu beachten, daß die Auflösung des aufgedampften Trennmittels um so rascher vonstatten geht, je höher die Temperatur des Lösungsmittels ist. Versuche haben dabei gezeigt, daß günstigste Verhältnisse vorliegen, bei denen das Auflösen des Trennmittels mit ausreichender Geschwindigkeit erfolgt und bei denen mit nur 2 Schleusen 6a, 6b zwischen dem Hochvakuumbereich des Aufdampfteils 2 und dem Kammerteil 7 ein Betrieb noch möglich ist, wenn folgende Bedingungen erfüllt sind:

Vakuum im Kammerteil 7: >53 mbar

Wassertemperatur: 35° C, was einem Dampfdruck von 53 mbar entspricht.

Im Kammerteil 7 bewirkt die auf 4-25°C gekühlte Oberfläche eines Kondensors 8, daß entstehender Wasserdampf kondensiert und in die Ablösestation 9 im Kammerteil 7 zurückläuft. Als Beispiel für die Vakuumverhältnisse und die zu installierende Pumpengrößen und -arten wurden für den Durchlauf eines Endlosbandes von 600 x 0,4 mm und einer offenen Spaltbreite über dem Träger 5 von je 0.2 x 600,2 mm für den Hin- und Herlauf des Trägers 5 zwischen dem Aufdampfteil 2 und dem Kammerteil 7 folgende Größen ermittelt:

| Ort | Vakuum | notwendige Saugleistung zur Überwindung der Schleusenströmung | Art der Vakuumpumpen |
|---|---|---|---|
| Aufdampfteil (2) | 10-4 mbar Strömung molekular | 5400 lit/sec. | Diffusionspumpen + mech. Pumpen nachgeschaltet |
| Schleuse (6a) | 0,2 mbar Strömung laminar | 11.700 $m^3$/h | Drehkolbengebläse + mech. Pumpen |
| Schleuse (6b) | 10 mbar Strömung laminar | 1380 $m^3$/h | mechanische Pumpen |
| Kammerteil (7) | 50 mbar | 100 $m^3$/h, nur zur Abpumpung von im Wasser gelöster Luft, Wasserdampf an Kondensor | mechanische Pumpen+ wassergek. Kondensor |

Es wäre natürlich möglich, den Träger 5 über weitere an das System angebaute Stufen und eine weitere Überdruckstufe, die das Ansaugen von Staub aus der Atmosphäre verhindert, von Luft zu Luft laufen zu lassen und dort die Ablösung des Produktes vom Träger 5 durchzuführen. Eine solche Anlage ist in abgewandelter Form in der Offenlegungsschrift DE 4020999 als Endlosbandanlage und in der GB 2072095 als eine Anlage mit mehreren Druckstufen entlang einer Großwalze zur Transfermetallisierung von Papier offenbart oder aus der Offenlegungsschrift DE 2747061 als reines Trägerband für die Metallisierung einer darauf aufgelegten sehr dünnen Kunststoffolie bekannt. Reine Luft-zu-Luft-Anlagen ohne Träger und zwar für die Metallisierung von Kunststoffolien sind in der EP 337369 beschrieben. Bei all diesen Anlagen müssen zur Herstellung von Pigmentplättchen Trägerfolien und weitere Maschinen zur Vor- und Nachbearbeitung der Folien verwendet werden. Der apparative Aufwand von Luft-zu-Luft-Anlagen ist wegen zusätzlicher Schleusenstufen im Bereich von 1000 bis 50 mbar wesentlich höher; ihr Energieverbrauch für die Vakuumpumpen ist daher doppelt so hoch wie der bei erfindungsgemäßen Anlagen.

Die Bandbedampfungsanlage nach dieser Erfindung benötigt nur zwei dynamische Schleusen 6a, 6b im Bereich zwischen 10$^{-4}$ bis 50 mbar. Noch günstiger stellen sich die Vakuumverhältnisse dar, wenn statt Wasser sekundäre oder tertiäre Alkohole als Lösungsmittel verwendet werden. Dieses setzt die Verwendung von Trennmitteln, welche in den genannten Stoffen gut löslich sind, voraus. Sekundäre und tertiäre Alkohole besitzen einen wesentlich geringeren Dampfdruck als Wasser und sind noch bei -5°C, was einem Dampfdruck von weniger als 0,01 mbar entspricht, gut pumpbar. Bevorzugt ist die Verwendung von sekundären oder tertiären Alkohole bei mehr als 0.05 mbar. Die Schleusen 6a und 6b können somit entfallen und das Kammerteil 7 schließt sich durch einen Schlitz abgetrennt direkt an das Aufdampfteil 2 an. Die wirtschaftlichen Vorteile einer solchen 2-Kammeranlage sind jedoch gering, weil die Anzahl der in sekundären oder tertiären Alkoholen löslichen und gut verdampfbaren Trennmittel begrenzt ist und diese Alkohole nicht umweltfreundlich sind.

Als Lösungsmittel sind jedoch auch verzweigte oder unverzweigte primäre Alkohole oder Gemische aus Wasser, verzweigten und unverzweigten primäre Alkohole, sekundären Alkoholen und tertiären Alkoholen geeignet.

Zur Führung des Trägers 5 in der Vakuumkammer 1 sind ferner vor dem Verdampfer 3 eine Umlenkwalze 16 und im Kammerteil 7 eine Ablösestation 9 vorgesehen.

Die Ablösestation 9 besteht aus einer Anzahl von Umlenkrollen 10, welche den Träger 5 in je einen heb- und absenkbaren Behälter 11a und 11b tauchen. Zum Anfahren der Anlage oder bei Abschaltvorgängen wird der erste Behälter 11a in Laufrichtung angehoben und dient solange als Ablösestation für das zu verwerfende Produkt, bis stabile Verhältnisse vorliegen. Dann werden der Behälter 11b, der als Sammler für gutes Material dient, angehoben und der Behälter 11a abgesenkt. Die Ablösung und das Sammeln des Produktes als Suspension erfolgen dann im Behälter 11b. Zur Beschleunigung der Auflösung des Trennmittels können bekannte Verfahren, bei denen Unterwasser-Hochdruckdüsen, Ultraschallschwinger oder rotierende Bürsten eingesetzt werden, verwendet werden. Die Suspension aus Produkt, Wasser und gelöstem Trennmittel wird kontinuierlich vom tiefsten Punkt des Behälters 11b abgesaugt und über eine Wasserpumpe 12 an die Atmosphäre gefördert und dort durch je einen Wechselfilter 13a und 13b gepreßt. Das Produkt aus diesen Filtern wird diskontinuierlich entnommen, mehrmals mit Reinwasser gespült, getrocknet, auf die gewünschte Teilchengröße gemahlen und geht dann zur Weiterverarbeitung in die Lack- oder Druckfarbenerzeugung oder wird anderweitig verwendet.

Der Träger 5 durchläuft nach dem Auftauchen aus dem Behälter 11b eine Spülstation 14 mit Wasser, das die gleiche Temperatur wie das Bad im Behälter 11b hat, sowie eine Abstreifstation 15 für Restwasser. Der Bahnweg führt über die Schleusen 6b und 6a in den Aufdampfteil 2 zurück, in dem dann der Träger über die Umlenkwalze 16 zum Verdampfer 3 für das Trennmittel und weiter zu den Verdampfern 4a, 4b, 4c geführt wird. Der Kreislauf ist hiermit geschlossen. An dem Träger 5 anhaftende Restfeuchte wird in den Schleusen 6a und 6b abgepumpt.

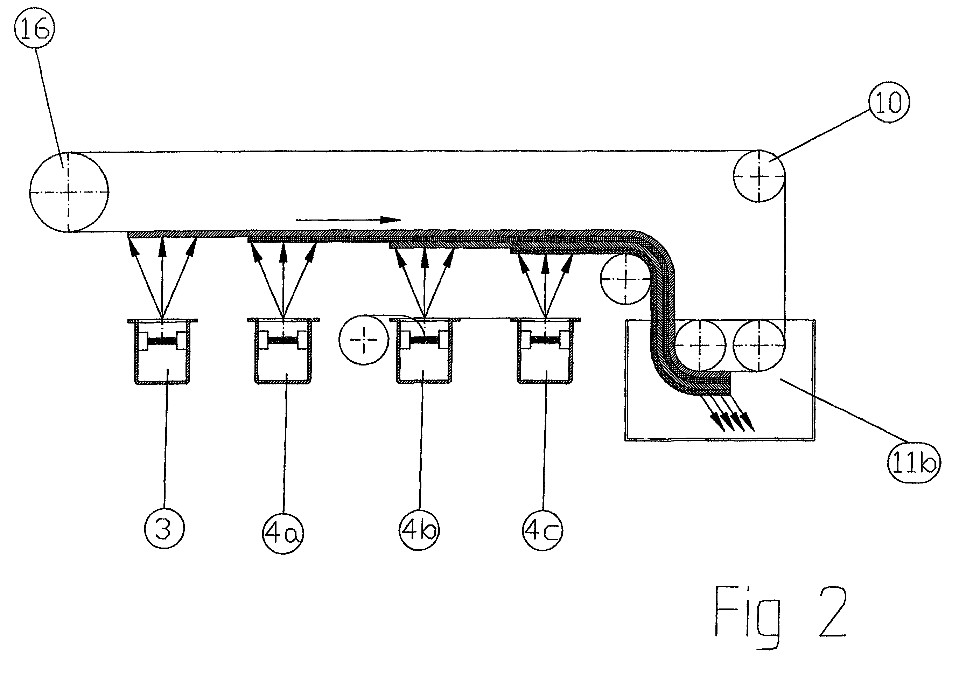

Fig. 2 zeigt den Schichtenaufbau und die Schichtenablösung im Verlauf eines Zyklus des Trägers 5.

Die Verwendung von mehreren verschiedenen Verdampfern 4a, 4b, 4c entlang der Laufrichtung des Trägers 5 gestattet die Herstellung einer großen Vielfalt von planparallelen Plättchen und Kombination hiervon, wie z.B.

| Produkt | Anwendung |
|---|---|
| Al | Metallic - Pigment für KFZ-Karosserielacke, Druckfarben |
| $SiO_2$ - Al - $SiO_2$, wobei Direktverdampfung von $SiO_2$ oder Aufdampfen von SiO-Schichten erfolgt | Anwendungen wie obenstehend, mit chemischer Schutzschicht gegen Korrosion |
| Ag | als Leitlack für Kontaktierungen |
| Ag - Cu - Ag | als preiswerter Leitlack |
| Ti ( > 2 μ Dicke ) | Farbig reflektierendes Produkt, nachfolgend bei 300°C an Luft oxidiert |
| Ti-silizid - Al - Ti-silizid | Bronze- oder goldfarbige Partikel |
| Edelmetalle | Katalysatoren |
| 3- Komp. Vielfachschichten | Mikrowellenabsorber |

Sowohl in den Fällen, in denen nur ein Verdampfer verwendet wird, als auch in den Fällen, in denen mehrere Verdampfer zum Einsatz gelangen, ist es notwendig, ein in Wasser oder Alkohol lösliches Trennmittel als erste Schicht auf den Träger 5 aufzudampfen, wobei das Flächengewicht typischerweise 0,05 bis 0,1 $g/m^2$ beträgt. Geeignete Trennmittel, die sich ohne Zersetzung verdampfen lassen, nicht oder wenig toxisch sowie wasserlöslich sind, sind beispielsweise: Wasserfreies Natriumchlorid, Kaliumchlorid, Lithiumchlorid, Natriumfluorid, Kaliumfluorid, Lithiumfluorid, Calciumfluorid, Natriumaluminiumfluorid (Kryolith) und Dinatrium-tetraborat.

Für das Trennmittel haben sich ferner als geeignet erwiesen Antimontrioxid, Boroxid, Calciumjodid, Cer(III) jodid, Lithiumjodid, Natriumjodid, Yttriumjodid, Lithiumsulfat, Kaliumsulfat, Natriumsulfat und andere Sulfate, Natriumhydroxid, Kaliumhydroxid, Yttriumbromid und andere Bromide.

Für den Betrieb der erfindungsgemäßen Bedampfungsanlage ist die Wahl des Trägerbandes von besonderer Bedeutung. Das Trägerband soll eine Oberfläche von sehr geringer Rauhtiefe aufweisen, nach dem Einziehen in die Bandbedampfungsanlage schweißbar sein und eine sehr gute chemische und mechanische Festigkeit aufweisen. Folgende Materialien sind dazu geeignet: Hochglanzgewalzter oder elektropolierter rostfreier Stahl, Superlegierungen wie INCONEL™ INCOLOY™ und andere, hochglanzpoliertes Nickel, aber auch galvanisch beschichtete Metalle, wobei die Beschichtung die chemische Beständigkeit sowie die Oberflächengüte und das Grundmaterial die gewünschte Festigkeit bestimmt. Desweiteren sind metallische Träger mit organischen Beschichtungen aus pigmentierten oder unpigmentierten Lacken harter und chemisch beständiger Duroplaste und Thermoplaste geeignet. Unter Verzicht auf die wesentliche längere Lebensdauer metallischer Träger eignen sich auch solche aus Polyimidfolie, welche bis 200°C unter Vakuum dauernd belastbar sind, wie z.B. KAPTON™.

Die Dicke des Trägerbandes 5 hat Einfluß auf die Durchmesser der in der Bandbedampfungsanlage verwendeten Umlenkwalzen. Bei einer erwarteten Lebensdauer von $10^6$ Umläufen ist mit etwa 10 Millionen Biegungen zu rechnen. Die Dauerstandsfestigkeit des Materials, die Dicke des Trägerbandes und der Durchmesser der Walzen müssen dabei aufeinander abgestimmt sein. Da handelsübliche Qualitäten von Stahl- oder Nickelbändern nur über 0,2 mm Dicke mit der notwendigen geringen Rauhtiefe erhältlich sind, ergeben sich als typische Walzendurchmesser etwa 250 mm für 0,2 mm oder 500 mm für 0,4 mm Blechdicke.

Die Wahl der Dicke vom Träger führt zu einem weiteren Kompromiß: Besonders bei Mehrschichtbedampfungen wird der Träger durch Kondensationswärme und durch Wärmestrahlung, die von den Verdampferquellen ausgeht, belastet, wobei keine Zwischenkühlung des Trägers durch gekühlte Walzen vorgesehen ist. Berechnungen und Messungen haben gezeigt, daß durch die gute Infrarot-Reflexion sowohl eines hochglänzenden Trägers als auch der meisten aufgedampften Metallschichten etwa 70 bis 85% der einfallenden Energie zurückgespiegelt werden. Ferner dürfen sich im Gegensatz zu Kunstofffolien Metallbänder während des Durchlaufs unter Vakuum bis 180° C erhitzen, während Kunststoffe bereits bei 60°C so stark ausgasen, daß es zu einem Vakuumzusammenbruch im Verdampfungsbereich kommen kann.

Die Auswirkungen dieses Sachverhaltns werden durch den folgenden Vergleich, der das Verhältnis der thermischen Belastbarkeit von verschiedenen Trägermaterialien mit typischen Dicken zeigt, deutlich. Entscheidend für die Erhitzung des Trägers ist dabei das Verhältnis von

$$1/(c_p \times \rho \times d)_{Metall} \, / \, 1/(c_p \times \rho \times d)_{Kunststoff}.$$

Dieses Verhältnis liegt für 400 μ Metall und 12μ Kunststoff bei etwa 1/66. Das bedeutet unter sonst gleichen Bedingungen, daß sich das Metallband im Vergleich zum Kunststoff nur mit 1,5 % erwärmt. Gleichzeitig gestattet ein Metallband eine um den Faktor f = (180-20)/(60-20) = 4 höhere zulässige Erwärmung. Das Metallband kann also gegenüber der Kunststofffolie eine 4 x 66 = 264-fache Wärmemenge aufnehmen, bevor die thermische Belastungsgrenze erreicht ist. Ein Wärmestau durch den wiederholten Umlauf des Trägers entsteht nicht, da er in der Ablösestation durch das Flüssigkeitsbad jedes Mal auf 35°C abgekühlt wird. Dieser nützliche Nebeneffekt erspart die Verwendung von innengekühlten Walzen.

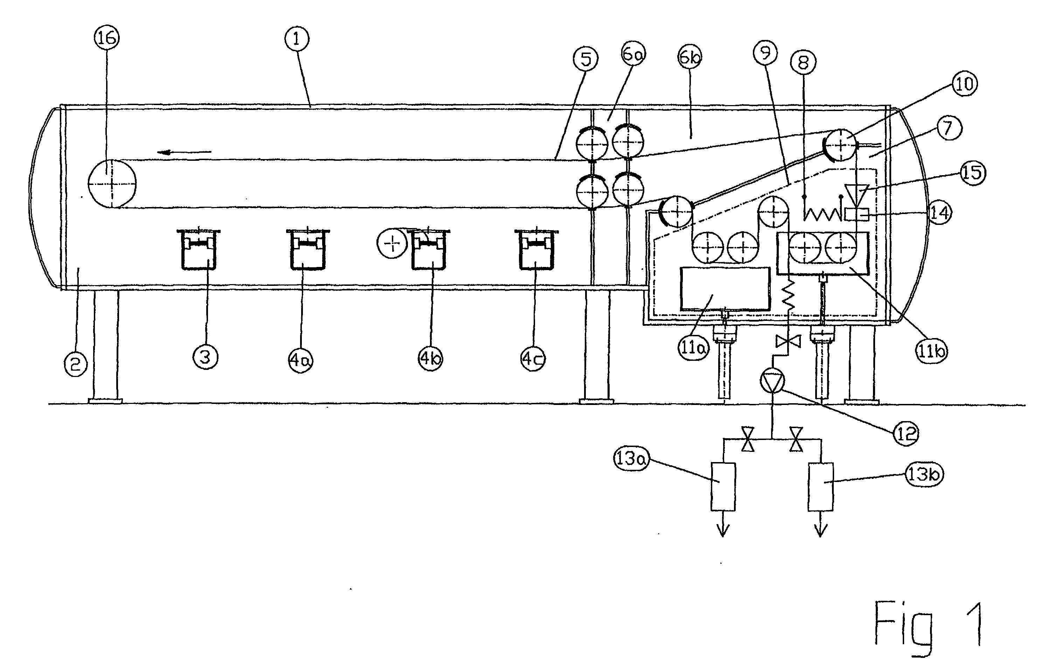

Das Verbinden der Enden des Trägerbandes 5 nach dem Einziehen in die Anlage erfolgt durch Stumpfschweißung, ohne Verdickung des Bandes an der Schweißstelle, da die Vakuumschleusen nur einen geringen Abstand zu feststehenden Teilen erlauben. Wichtig für die Bahnführung ist der in Fig. 1 gezeigte Bahnverlauf: Nach der Bedampfung des Trägers soll die Bahn auf der aufgedampften Seite berührungslos durch alle Schleusen laufen, damit die aufgedampften Schichten nicht beschädigt werden.

Die beschriebene Bandbedampfungsanlage erlaubt technische Bahngeschwindigkeiten von bis zu 350 m/ min, wobei jedoch das synchrone Verhalten aller Stufen Voraussetzung ist. Die Aufdampfgeschwindigkeiten sind dabei durch geeignete, bekannte Kontrollmechanismen den gewünschten Schichtdicken entsprechend anzupassen.

Schichtdicken-Meßsysteme, welche über sehr lange, in Tagen gemessene Zeiträume die von jedem Verdampfer erzeugte Schichtdicke messen und regeln lassen, sind in der DE 4338907 veröffentlicht.

Die Ablösestation 9 ist so auszulegen, daß auch bei maximaler Bahngeschwindigkeit das Produkt vom Träger 5 noch vollkommen abgelöst wird. Da diese Station bei einem Vakuum von nur etwa 50 mbar betrieben wird, ist eine Anpassung durch Vergrößerung der Kammerlänge und der Pumpkapazität bei moderaten Kosten möglich.

Der Betrieb der Anlage bis zu dem Zeitpunkt, zu dem Wartungs- und Reinigungsarbeiten an den Verdampfern eine Unterbrechung erforderlich sind, ist kontinuierlich über Zeiträume von mehreren Tagen möglich. Dieses setzt die Verwendung von kontinuierlich bestückbaren Verdampfern bekannter Bauart voraus.

Als Beispiel für die Kapazität einer erfindungsgemäßen Bandbedampfungsanlage mit 600 mm Trägerbreite und einer Bahngeschwindigkeit von 300 m/min errechnet sich eine pro Stunde produzierte Menge an planparallelen Plättchen aus Aluminium, die ausreicht, um 108 PKWs, die jeweils eine zu lackierende Oberfläche von 25 m$^2$ aufweisen, mit einem Metallic-Lack zu spritzen, wobei eine 4-lagige Deckung der Plättchen vorliegt.

Die vorstehend beschriebenen Ausführungsbeispiele für die Anlage und das Verfahren können wie folgt abgewandelt werden:

Es kann ein zusätzlicher Trennmittelverdampfer jeweils nach einem Produktverdampfer eingebaut werden. Dadurch können nun pro Umlauf des Trägers mehrere Lagen eines Produktes abgelöst werden. Als Ergebnis davon läßt sich die Kapazität der Anlage vervielfachen.

Alternativ oder zusätzlich zu der vorstehend genannten Abwandlung ermöglicht die Verwendung von unterschiedlichen Oberflächenstrukturen des Trägers eine Beeinflussung des Glanzgrades des Produktes.

Statt des Endlosbandes 5 kann jedoch auch ein Rollenmaterial zwischen zwei Wicklern vorgesehen sein. In diesem Fall erfolgt dann vor der Trennmittelbedampfung und dem Aufdampfen der Schichten ein Abrollen von einem der Wickler sowie nach dem Ablösen ein Aufrollen des Trägers 5 auf dem anderen Wickler. Danach kann der Aufrollwickler wieder abgerollt werden, wobei das Bedampfen mit einem Trennmittel und das Aufdampfen der Schichten in umgekehrter Laufrichtung erfolgt. Bei dieser Anordnung sind zwei Trennmittelverdampfer 3 notwendig, die sich zu beiden Seiten der Verdampfereinrichtung 4a, 4b, 4c befinden, wobei jeweils der der Verdampfereinrichtung folgende Trennmittelverdampfer 3 abgeschaltet ist. Die Zahl der Ablösekammern 7 erhöht sich auf zwei, jeweils symmetrisch zu der Verdampfereinrichtung.

Die Erfindung betrifft somit eine Mehrkammeranlage zur Erzeugung von im Vakuum aufgedampften Schichten auf einem endlos umlaufenden Träger, mit folgenden seriellen Schritten: Aufdampfung eines Trennmittels im Hochvakuum - Aufdampfung einer oder mehrerer Schichten aus Metall, Oxiden, Fluoriden, Nitriden im Hochvakuum - Ablösen der Aufdampfschichten vom endlosen Träger unter Grobvakuum. Die aufgedampften Schichten liegen danach in einer eigenen durch dynamische Schleusen von der Aufdampfkammer abgetrennten Vakuumstufe als Suspension feiner Plättchen in einem Gemisch aus Lösungsmittel und darin gelöstem Trennmittel vor. Die Suspension kann nun kontinuierlich oder diskontinuierlich aus dem Vakuumraum zur weiteren Verarbeitung ausgeschleust werden. Das Lösungsmittel kann Wasser in einer Vakuumumgebung von mehr als 20 mbar oder sekundäre oder tertiäre Alkohole bei mehr als 0,05 mbar sein.

## Patentansprüche

1.  Vorrichtung zur Herstellung planparalleler Plättchen mit

    einer Aufdampfkammer (2),
    einem Träger (5),
    einer in der Aufdampfkammer (2) vorgesehenen ersten Verdampfungseinrichtung (3) zum Aufbringen eines Trennmittels
    auf den Träger (5) bei einem Druck unterhalb des Atmosphärendrucks,
    einer zweiten Verdampfungseinrichtung (4a, 4b, 4c) zum Aufbringen von zumindest einer Schicht auf den mit dem Trennmittel versehenen Träger bei einem Druck unterhalb des Atmosphärendrucks,
    einer Ablösekammer (7), und
    einer in der Ablösekammer vorgesehenen Ablöseeinrichtung (11a, 11b) zum Erzeugen einer Suspension, in der das aufgebrachte Trennmittel in gelöstem Zustand und die zumindest eine aufgebrachte Schicht in Form von planparallelen Plättchen als Suspension vorliegt, bei einem Druck, der höher als der Drunk in der Aufdampfkammer und geringer als der Atmosphärendruck ist.

2.  Vorrichtung nach Anspruch 1, wobei die zumindest eine Schicht Metall oder zumindest eine Schicht eines Metalloxids oder eines Fluorids und eine weitere verdampfbare Substanz aufweist.

3.  Vorrichtung nach Anspruch 1 oder 2, wobei die zweite Verdampfungseinrichtung zumindest zwei Schichten erzeugt, zwischen denen sich Trennmittel befindet.

4.  Vorrichtung nach einem der vorhergehenden Ansprüche, wobei das Trennmittel ein im Hochvakuum unzersetzt verdampfbarer wasserlöslicher Stoff aus der Gruppe der Chloride, Fluoride, Borate, Bromide, Jodide oder Sulfate oder Antimontrioxid, Boroxid, Natriumhydroxid oder Kaliumhydroxid ist.

5.  Vorrichtung nach einem der vorhergehenden Ansprüche, wobei die Suspension Wassers verzweigte oder unverzweigte primäre Alkohole, sekundäre Alkohole oder tertiäre Alkohole oder Gemische aus diesen Alkoholen enthält.

6.  Vorrichtung nach einem der vorhergehenden Ansprüche, wobei der Träger (5) aus einer rostfreien Stahllegierung, Nickel, einem Metall, das eine galvanische Beschichtung mit einem weiteren Metall oder eine organische Beschichtung mit einem Duroplast- oder Thermoplastwerkstoff aufweist, oder einer Polyimidfolie besteht und eine Dicke zwischen 20 und 2000 μm hat.

7.  Vorrichtung nach einem der vorhergehenden Ansprüche, wobei zwischen der Aufdampfkammer (2) und der Ablösekammer (7) dynamisch gepumpte Schleusen (6a, 6b) vorgesehen sind.

**8.** Vorrichtung nach einem der vorhergehenden Ansprüche, wobei der Träger (5) auf einer Endlosbahn bewegbar ist.

**9.** Vorrichtung nach einem der Ansprüche 1 bis 7, wobei in Laufrichtung vor der ersten Verdampfungseinrichtung (3) eine Abrolleinreichtung für den Träger (5) vorgesehen ist und in Laufrichtung eine Ablöseeinrichtung (11a, 11b) und eine Aufrolleinrichtung für den Träger (5) folgen.

**10.** Verfahren zur Herstellung von planparallelen Plättchen mit den Schritten

> **a)** Aufdampfen eines Trennmittels auf einen Träger zum Erzeugen einer Trennmittelschicht bei einem Druck unterhalb des Atmosphärendruckes,
> **b)** Aufdampfen von zumindest einer Schicht auf die Trennmittelschicht bei einem Druck unterhalb des Atmosphärendruckes, und
> **c)** Lösen der Trennmittelschicht in einem Lösungsmittel und Erzeugen einer Suspension, in der die zumindest eine Schicht in Form von planparallelen Plättchen vorliegt, wobei Schritt c) bei einem Druck ausgeführt, der höher als der Druck in Schritten a) und b) und niedriger als der Atmosphärendruck ist.

**11.** Verfahren nach Anspruch 10, wobei Schritt b) die Teilschritte aufweist

> b.1) Aufdampfen einer ersten Schicht auf die Trennmittelschicht,
> b.2) Aufdampfen eines Trennmittels auf die erste Schicht zum Erzeugen einer zweiten Trennmittelschicht, und
> b.3) Aufdampfen einer zweiten Schicht auf die zweite Trennmittelschicht,

> und in Schritt c) die erste und die zweite Schicht in der Suspension vorliegen.

**12.** Verfahren nach Anspruch 10 oder 11, wobei das Lösungsmittel Wasser aufweist, das Trennmittel ein im Hochvakuum unzersetzt verdampfbarer wasserlöslicher Stoff ist und die zumindest eine Schicht Metall oder zumindest eine Schicht eines Metalloxids oder eines Fluorids und eine weitere verdampfbare Substanz aufweist.

**13.** Verfahren nach einem der Ansprüche 10 bis 12, wobei der Träger (5) aus einer rostfreien Stahllegierung, Nickel, einem Metall, das eine galvanische Beschichtung mit einem weiteren Metall oder eine organische Beschichtung mit einem Duroplast- oder Thermoplastwerkstoff aufweist, oder einer Polyimidfolie besteht.

**14.** Verfahren nach einem der Ansprüche 10 bis 13, wobei der Träger (5) endlos ist.

**15.** Verfahren nach einem der Ansprüche 10 bis 13, wobei vor Schritt a) der Träger (5) abgerollt wird und nach Schritt c) ein Aufrollen des Trägers (5) erfolgt.

**16.** Verfahren nach einem der Ansprüche 10 bis 13 und nach Anspruch 15, wobei die Schritte a), b), c) durch Einbau je eines weiteren Trennmittelverdampfers (3) und einer weiteren Ablöseeinrichtung (11a, 11b) symmetrisch zu der Verdampfereinrichtung (4a, 4b, 4c) durch abwechselndes Auf- und Abrollen des Trägers (5) erfolgen können.

**Claims**

**1.** Apparatus for producing plane-parallel flakes, including

> a vapor deposition chamber (2),
> a substrate,
> first evaporation means (3) provided in said vapor deposition chamber (2) for application of a separating agent on said substrate (5) at a pressure lower than atmospheric pressure,
> second evaporation means (4a, 4b, 4c) for application of at least one layer on said substrate provided with the separating agent at a pressure lower than atmospheric pressure,
> stripping means (11a, 11b) provided in said stripping chamber, for producing a suspension wherein the applied separating agent is present in the dissolved state and said at least one applied layer is present in the form of plane-parallel flakes as a suspension, at a pressure which is higher than the pressure in said vapor deposition chamber and lower than atmospheric pressure.

**2.** Apparatus according to claim 1, wherein said at least one layer includes metal or at least one layer of a metal oxide or of a fluoride and another vaporisable substance.

3. Apparatus according to claim 1 or 2, wherein said second evaporation means produce at least two layers having separating agent arranged therebetween.

4. Apparatus according to any one of the preceding claims, wherein said separating agent is a water-soluble substance vaporisable in high vacuum without decomposition from among the group of chlorides, fluorides, borates, bromides, iodides or sulfates or antimony trioxide, boron oxide, sodium hydroxide or potassium hydroxide.

5. Apparatus according to any one of the preceding claims, wherein said suspension contains water, branched oder linear primary alcohols, secondary alcohols or tertiary alcohols, or mixtures of these alcohols.

6. Apparatus according to any one of the preceding claims, wherein said substrate (5) consists of a stainless steel alloy, nickel, a metal comprising an electrodeposit of another metal or an organic coating of a thermoset or thermoplastic material, or a polyimide film, and has a thickness between 20 and 2000 $\mu$m.

7. Apparatus according to any one of the preceding claims, wherein dynamically pumped locks (6a, 6b) are provided between said vapor deposition chamber (2) and said stripping chamber (7).

8. Apparatus according to any one of the preceding claims, wherein said substrate is (5) movable on an endless trajectory.

9. Apparatus according to any one of claims 1 to 7,
wherein upstream from said first evaporation means (3) means for reeling off said substrate (5) are provided, and stripping means (11a, 11b) and means for rolling up said substrate (5) follow in a downstream direction.

10. Method for producing plane-parallel flakes, including the steps:

a) vapor deposition of a separating agent on a substrate for producing a separating agent layer at a pressure lower than atmospheric pressure,
b) vapor deposition of at least one layer on said separating agent layer at a pressure lower than atmospheric pressure, and
c) dissolution of said separating agent layer in a solvent, and production of a suspension wherein said at least one layer is present in the form of plane-parallel flakes,

wherein step c) is carried out at a pressure which is higher than the pressure in steps a) and b) and lower than atmospheric pressure.

11. Method according to claim 10, wherein step b) includes the partial steps:

b.1) vapor deposition of a first layer on said separating agent layer,
b.2) vapor deposition of a separating agent on said first layer to produce a second separating agent layer, and
b.3) vapor deposition of a second layer on said second separating agent layer,

and in step c) said first and said second layers are present in said suspension.

12. Method according to claim 10 or 11, wherein said solvent includes water, said separating agent is a water-soluble substance vaporisable in high vacuum without decomposition, and said at least one layer comprises metal or at least one layer of a metal oxide or of a fluoride and another vaporisable substance.

13. Method according to any one of claims 10 to 12,
wherein said substrate (5) consists of a stainless steel alloy, nickel, a metal comprising an electrodeposit of another metal or an organic coating of a thermoset or thermoplastic material, or a polyimide film.

14. Method according to any one of claims 10 to 13,
wherein said substrate (5) is endless.

15. Method according to any one of claims 10 to 13,

wherein said substrate (5) is reeled off prior to step a), and rolling up said substrate (5) takes place after step c).

16. Method according to any one of claims 10 to 13 and according to claim 15, wherein steps a), b), c) may be performed by installation of one more separating agent vaporiser (3) and one more stripping means (11a, 11b) each symmetrically with respect to said evaporation means (4a, 4b, 4c) through alternatingly reeling off and rolling up said substrate (5).

**Revendications**

1. Dispositif pour fabriquer des plaquettes à faces planes et parallèles comportant

   une chambre de dépôt par évaporation (2),
   un support (5),
   un premier dispositif d'évaporation (3) prévu dans la chambre de dépôt par évaporation (2) pour déposer un agent de séparation sur le support (5), à une pression inférieure à la pression atmosphérique,
   un second dispositif d'évaporation (4a, 4b, 4c) pour déposer au moins une couche sur le support pourvu de l'agent de séparation, à une pression inférieure à la pression atmosphérique,
   une chambre de détachement (7),
   un dispositif de détachement (11a, 11b) prévu dans la chambre de détachement pour produire une suspension, dans laquelle l'agent de séparation appliqué est présent à l'état dissous et la au moins une couche déposée est présente sous la forme de plaquettes à faces planes et parallèles en tant que suspension, à une pression qui est supérieure à la pression régnant dans la chambre de dépôt par évaporation et est inférieure à la pression atmosphérique.

2. Dispositif selon la revendication 1, dans lequel la au moins une couche comporte un métal ou au moins une couche d'un oxyde métallique ou d'un fluorure et une autre substance évaporable.

3. Dispositif selon la revendication 1 ou 2, dans lequel le second dispositif d'évaporation comporte au moins deux couches, entre lesquelles est situé l'agent de séparation.

4. Dispositif selon l'une des revendications précédentes, dans lequel l'agent de séparation est une substance soluble à l'eau, évaporable sans décomposition sous vide poussé, et qui fait partie des chlorures, des fluorures, des borates, des bromates, des iodures ou des sulfates ou du trioxyde d'antimoine, de l'oxyde de bore, de l'hydroxyde de sodium ou de l'hydroxyde de potassium.

5. Dispositif selon l'une des revendications précédentes, dans lequel la suspension contient de l'eau, des alcools primaires ramifiés ou non ramifiés, des alcools secondaires ou des alcools tertiaires ou des mélanges de ces alcools.

6. Dispositif selon l'une des revendications précédentes, dans lequel le support (5) est formé par un alliage d'acier inoxydable, du nickel, un métal, qui comporte un revêtement galvanique contenant un autre métal ou un revêtement organique contenant un matériau thermodurcissable ou une matière thermoplastique, ou par une feuille de polyimide et possède une épaisseur une épaisseur comprise entre 20 et 2000 $\mu$m.

7. Dispositif selon l'une des revendications précédentes, dans lequel des sas (6a, 6b) pompés de façon dynamique sont prévus entre la chambre de dépôt par évaporation (2) et la chambre d'étagement (7).

8. Dispositif selon l'une des revendications précédentes, dans lequel le support (5) est déplaçable sur une bande sans fin.

9. Dispositif selon l'une des revendications 1 à 7, dans lequel un dispositif de déroulement est prévu, pour le support (5), en amont du premier dispositif d'évaporation (3) dans la direction de circulation, et qu'un dispositif de dissolution (11a, 11b) et un dispositif d'enroulement pour le support (5) suivent dans la direction de circulation.

10. Procédé pour fabriquer des plaquettes à faces planes et parallèles, comprenant les étapes comprenant:

    a) le dépôt par évaporation un agent de séparation sur un support pour produire une couche de l'agent de séparation à une pression inférieure à la pression atmosphérique,

b) le dépôt par évaporation au moins une couche sur la couche de l'agent de séparation à une pression inférieure à la pression atmosphérique, et

c) la dissolution la couche de l'agent de séparation avec un solvant et la production d'une suspension, dans laquelle la au moins une couche est présente sous la forme de plaquettes à faces planes et parallèles,

l'étape c) étant exécutée à une pression qui est supérieure à la pression présente lors des étapes a) et b) et inférieure à la pression atmosphérique.

**11.** Procédé selon la revendication 10, selon lequel l'étape b) comprend les étapes partielles comprenant:

b.1) le dépôt par évaporation d'une première couche sur la couche de l'agent de séparation,

b.2) le dépôt par évaporation d'un agent de séparation sur la première couche pour produire une seconde couche de l'agent de séparation, et

b.3) le dépôt une seconde couche sur la seconde couche de l'agent de séparation, et

lors de l'étape c), les première et seconde couches sont présentes dans la suspension.

**12.** Procédé selon la revendication 10 ou 11, selon lequel le solvant de dissolution comporte de l'eau, l'agent de séparation est une substance soluble à l'eau, pouvant être évaporée sans décomposition sous vide poussé et la au moins une couche comporte un métal ou au moins une couche d'un oxyde métallique ou d'un fluorure et une autre substance évaporable.

**13.** Procédé selon l'une des revendications 10 à 12, selon lequel le support (5) est constitué par un alliage d'acier inoxydable, du nickel, un métal, qui possède un revêtement galvanique contenant un autre métal ou un revêtement organique contenant une matière plastique thermodurcissable ou une matière thermoplastique, ou une feuille de polyimide.

**14.** Procédé selon l'une des revendications 10 à 13, dans lequel le support (5) est un support sans fin.

**15.** Procédé selon l'une des revendications 10 à 13, selon lequel avant l'étape a), le support (5) est déroulé et, après l'étape c), un enroulement du support (5) est réalisé.

**16.** Procédé selon l'une des revendications 10 à 13 et selon la revendication 15, selon lequel les étapes a), b), c) peuvent être exécutées, moyennant le montage d'un autre évaporateur respectif pour l'agent de séparation et d'un autre dispositif de détachement (11a, 11b), symétriquement par rapport au dispositif d'évaporation (4a, 4b, 4c), moyennant un enroulement et un déroulement alterné du support (5).

Fig 1

EP 0 990 715 B1

Fig 2